# EUROPÄISCHE PATENTANMELDUNG

(11) **EP 0 720 288 A1**
(43) Veröffentlichungstag der Anmeldung: **03.07.1996**
(21) Anmeldenummer: 94120925.6
(22) Anmeldetag: 30.12.1994
(51) Int. Cl.: H03H 1/00, H05K 9/00

(54) **Verschraubung für Einführungen von Kabeln und/oder Leitungen**

(71) Anmelder: ENDRESS + HAUSER GMBH + CO., D-79689 Maulburg (DE)
(72) Erfinder: Grittke, Udo, D-79541 Lörrach (DE)

(57) **Zusammenfassung**

Zur einfachen Ausrüstung von neuen und zur einfachen Nachrüstung von alten Geräten, sowie zur einfachen Störbefreiung von handelsüblichen Verschraubungen mit einer Innenbohrung (1) für Einführungen von Kabeln und/oder Leitungen in eine Wand (3) eines Gehäuses einer elektrischen und/oder elektronischen Anordnung ist eine Druckschraube (2) vorgesehen, die entweder in ein in der Wand (3) angebrachtes Gewinde (4) eingeschraubt oder in einen in dieses Gewinde eingeschraubten bzw. in eine in der Wand angebrachte Bohrung eingesetzten und mittels einer Gegenmutter (7) fixierten Zwischenstutzen (5) eingeschraubt ist. Ferner ist eine Ferrit-Hülse (8) vorhanden, deren Innen-Durchmesser dem Außen-Durchmesser der Leitungen bzw. des Kabels entspricht und die in die Innenbohrung (1) der Druckschraube (2) und/oder in die Innenbohrung (1) des Zwischenstutzens (5) eingesetzt ist.

## Beschreibung

Die Erfindung betrifft eine Verschraubung mit Innenbohrung für Einführungen von Kabeln und/oder Leitungen in eine Wand eines Gehäuses einer elektrischen und/oder elektronischen Anordnung, wie sie z.B. in der deutschen Norm DIN 46 320 beschrieben ist.

Diese Verschraubungen enthalten nichts, was dem Schutz vor Störungen dienen könnte, die entweder über die Leitungen bzw. Kabel in die Anordnung gelangen oder über sie emittiert werden können.

In der JP-A 1 - 170 306 ist eine einteilige Einführung von Kabeln und/oder Leitungen in eine Wand eines Gehäuses einer elektrischen und/oder elektronischen Anordnung beschrieben
- mit einer Innenbohrung zur Aufnahme der Kabel und/oder Leitungen,
- mit einem in die Wand ragenden Teil,
- mit einem einen größeren Außen-Durchmesser als dieses Teil aufweisenden Ansatz,
   -- in den ein Ferrit-Ring von der gehäuse-abgewandten Seite her eingesetzt ist, und
- mit einem Befestigungslöcher aufweisenden Flansch,
   -- über die die Einführung an der Wand festschraubbar ist.

Bei dieser Einführung handelt es sich somit um ein speziell zur Aufnahme des Ferrit-Ringes konstruiertes Bauteil, das lediglich für Neubestückungen von zu fertigenden Geräten, jedoch nicht für die möglichst einfache Nachbestückung von bereits gefertigten oder schon verkauften Geräten geeignet ist. Bei diesen muß nämlich eine bereits vorhandene Einführung durch die spezielle, ferrit-ring-bestückte Einführung ersetzt werden, da eine Nachrüstung mit dem Ferrit-Ring nicht möglich ist. Außerdem benötigt die vorbeschriebene Anordnung innerhalb des Gehäuses ausreichend Platz.

Zur Lösung dieser Probleme, also insb. zur einfachen und platzsparenden Ausrüstung von neuen und zur einfachen Nachrüstung von "alten" Geräten, sowie zur einfachen Störbefreiung von handelsüblichen Verschraubungen besteht daher die Erfindung in einer Verschraubung mit Innenbohrung für Einführungen von Kabeln und/oder Leitungen in eine Wand eines Gehäuses einer elektrischen und/oder elektronischen Anordnung
- mit einer Druckschraube, die
   -- entweder in ein in der Wand angebrachtes Gewinde eingeschraubt
   -- oder in einen in dieses Gewinde eingeschraubten bzw. in einen in der Wand angebrachten Bohrung eingesetzten und mittels einer Gegenmutter fixierten Zwischenstutzen eingeschraubt ist, und
- mit einer Ferrit-Hülse,
   -- deren Innen-Durchmesser dem Außen-Durchmesser der Leitungen bzw. des Kabels entspricht und
   -- die in die Innenbohrung der Druckschraube und/oder in die Innenbohrung des Zwischenstutzens eingesetzt ist.

Nach einer Weiterbildung der Erfindung kann eine Vorrichtung für die Zugentlastung und den Verdrehungsschutz der Leitungen bzw. Kabel vorgesehen sein.

Ein Vorteil der Erfindung besteht darin, daß Geräte, die eine mit der Ferrit-Hülse ausgerüstete Verschraubung aufweisen, dieselbe Explosionsschutz-Klasse wie Geräte mit einer Verschraubung ohne die Ferrit-Hülse haben. Die Erfindung wird nun anhand eines Ausführungsbeispiels unter Bezugnahme auf die Zeichnungen näher beschrieben, in der gleiche Teile mit denselben Bezugszeichen versehen sind.
- Fig. 1 zeigt: in teilweise geschnittener Seitenansicht eine Verschraubung in Form einer in eine Wand eingeschraubten Druckschraube,
- Fig. 2 zeigt: in teilweise geschnittener Seitenansicht eine Verschraubung in Form eines in eine Wand eingeschraubten Zwischenstutzens mit darin eingeschraubter Druckschraube, und
- Fig. 3 zeigt: in teilweise geschnittener Seitenansicht eine Verschraubung in Form eines in einer Wand mittels einer Gegenmutter fixierten Zwischenstutzens mit darin eingeschraubter Druckschraube.

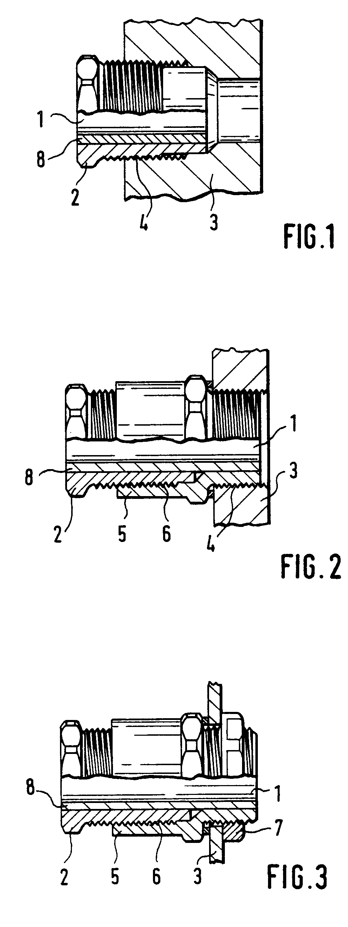

Die in Fig. 1 in teilweise geschnittener Seitenansicht dargestellte erste Variante einer Verschraubung mit Innenbohrung 1 besteht lediglich aus einer Druckschraube 2, die in ein in einer Wand 3 eines Gehäuses eines elektronischen oder elektrischen Gerätes angebrachtes Gewinde 4 eingeschraubt ist.

Die in Fig. 2 in teilweise geschnittener Seitenansicht dargestellte zweite Variante einer Verschraubung mit Innenbohrung 1 besteht aus der Druckschraube 2 von Fig. 1 und ferner aus einem Zwischenstutzen 5, der in der Wand 3 in das Gewinde 4 des Gehäuses eingeschraubt ist. Ferner hat der Zwischenstutzen 5 ein Innengewinde 6, in das die Druckschraube 2 eingeschraubt ist.

Die in Fig. 3 in teilweise geschnittener Seitenansicht dargestellte dritte Variante einer Verschraubung mit Innenbohrung 1 besteht aus der Druckschraube 2 von Fig. 1 und aus dem Zwischenstutzen 5 von Fig. 2, der nun allerdings in eine in der Wand 3 des Gehäuses angebrachte Bohrung eingesetzt und darin mittels einer Gegenmutter 7 fixiert ist. Die Druckschraube 2 ist wieder in das Innengewinde 6 des Zwischenstutzens 5 eingeschraubt.

Die Innenbohrung 1 dient bei allen drei Varianten zur Aufnahme und damit der Einführung von wegen der Übersichtlichkeit nicht dargestellten Leitungen bzw. Kabeln, über die die im Gehäuse untergebrachte Elektrik/Elektronik mit anderen elektrischen oder elektronischen Einheiten zu verbinden ist.

In die Innnenbohrung 1 ist eine Ferrit-Hülse 8 eingesetzt, deren Innen-Durchmesser dem Außen-Durchmesser der Leitungen bzw. des Kabels entspricht. Die Ferrit-Hülse 8 kann sich, wie in den Fig. 1 bis 3 gezeigt ist, über die gesamte Länge der Innenbohrung 1 erstrecken; es ist jedoch auch möglich, die Ferrit-Hülse 8 kürzer als die Innenbohrung 1 zu dimensionieren und sie an geeigneter Stelle längs der Innenbohrung 1, insb. an deren gehäuse-abgewandtem Ende, als Ferrit-Ring anzuordnen.

Die drei Varianten der Verschraubung nach der Erfindung können noch mit einer üblichen Vorrichtung für die Zugentlastung und den Verdrehungsschutz der Leitungen/Kabel ausgestattet werden. Dies ist in den Figuren der Zeichnung nicht dargestellt. In üblicher Weise kann hierzu ein Ring aus einem elastisch verformbaren Material dienen, der in der Druckschraube angeordnet ist und dessen lichte Weite sich beim Einschrauben der Druckschraube 2 verringert.

## Patentansprüche

1. Verschraubung mit Innenbohrung (1) für Einführungen von Kabeln und/oder Leitungen in eine Wand (3) eines Gehäuses einer elektrischen und/oder elektronischen Anordnung
- mit einer Druckschraube (2), die
-- entweder in ein in der Wand (3) angebrachtes Gewinde (4) eingeschraubt
-- oder in einen in dieses Gewinde eingeschraubten bzw. in einen in der Wand angebrachten Bohrung eingesetzten und mittels einer Gegenmutter (7) fixierten Zwischenstutzen (5) eingeschraubt ist, und
- mit einer Ferrit-Hülse (8),
-- deren Innen-Durchmesser dem Außen-Durchmesser der Leitungen bzw. des Kabels entspricht und
-- die in die Innenbohrung (1) der Druckschraube (2) und/oder in die Innenbohrung (1) des Zwischenstutzens (5) eingesetzt ist.

2. Verschraubung nach Anspruch 1 mit einer Vorrichtung für die Zugentlastung und den Verdrehungsschutz der Leitungen bzw. Kabel.
